# EUROPEAN PATENT APPLICATION

(11) **EP 4 852 699 A1**
(43) Date of publication of application: **09.12.2026**
(21) Application number: 26182776.0
(22) Date of filing: 03.06.2026
(51) Int. Cl.: H10W 40/20, H10W 40/00, H10W 40/22, H10W 40/25, H10W 90/20

(54) **THERMAL MANAGEMENT FOR HIGH BANDWIDTH MEMORY DEVICE**

(30) Priority: 03.06.2025 US 202519226825
(71) Applicant: Google LLC, Mountain View, CA 94043 (US)
(72) Inventor: BEAUCHEMIN, Melanie, Mountain View, 94043 (US); MOHAMMED, Ilyas, Mountain View, 94043 (US); TOMA, Horia Alexandru, Mountain View, 94043 (US); IYENGAR, Madhusudan Krishnan, Mountain View, 94043 (US)
(74) Representative: Betten & Resch

(57) **Abstract**

This disclosure relates to high bandwidth memory (HBM) devices and methods of assembling the HBM devices that are designed to uniformly disperse heat generated by the HBM via a high thermal conduction pathway. The pathway is formed using a conductivity layer and a plurality of posts integrated into the HBM device. The conductivity layer comprises high thermal conductivity material and is adjacent to the logic die of the HBM device to help prevent the formation of hot spots and reduce the chance of overheating of the logic die.

## Description

### BACKGROUND

The increasing volume of data and the widespread use of high-performance processors in both user devices and data centers have driven the need for systems with higher bandwidth memory capacity. High bandwidth memory (HBM) capacity is typically increased by stacking additional dynamic random-access memory (DRAM) chips or layers. A logic die, usually located at the bottom of the HBM device, serves as the base and controller for the HBM. A thermal management device is positioned atop the DRAM stack to cool the entire HBM device. However, as the number of DRAM layers increases, power dissipation, and consequently the heat generated by the logic die, also increases. As a result, thermal management devices often struggle to adequately cool the logic die within the HBM.

The logic die typically accounts for the highest power dissipation within the HBM, often generating approximately ten times more power than the DRAM stack. Moreover, the heat generated by the logic die tends to be concentrated in localized areas, creating hot spots, i.e. regions of elevated temperature. These hot spots and the overall increased thermal load can lead to reduced device lifespan, higher error rates, and degraded performance. Consequently, the logic die is generally the hottest component in the HBM stack. In some instances, the temperature differential between the logic die and areas adjacent to the thermal management device may exceed 40°C.

Various approaches have been proposed to address the thermal management challenges in HBM devices. One approach involves enhancing the external cooling solution by improving the performance of the thermal management device by including thermal interface material. However, this method typically yields only moderate improvements, as the cooling solution is located relatively far from the primary heat source, the logic die. Another approach focuses on reducing internal thermal resistance within the HBM by decreasing the thermal resistance of the DRAM underfill. This can be achieved by increasing the thermal conductivity of the underfill material or reducing its thickness. In some examples, hybrid bonding techniques are employed to eliminate the need for underfill and micro-bumps entirely. While this method can significantly improve thermal performance, it is primarily intended to increase the stacking density of DRAM dies within the HBM, which may negate thermal benefits due to the additional heat generated by the increased number of DRAM dies.

Despite these improvements, a thermal bottleneck remains at the logic die, which continues to experience localized power densities that result in hot spots.

### BRIEF SUMMARY

Aspects of this disclosure relate to HBM devices and structures and methods of assembling the HBM devices that are designed to uniformly disperse heat generated by the HBM via a high thermal conduction pathway. The pathway may be formed using a conductivity layer integrated into the HBM device, comprising high thermal conductivity material and including a plurality of posts.

According to one aspect of the disclosure, the pathway is formed using a conductivity layer and a plurality of posts integrated into the HBM device. The conductivity layer comprises high thermal conductivity material and is adjacent to the logic die of the HBM device to help prevent the formation of hot spots and reduce the chance of overheating of the logic die.

According to another aspect of the present disclosure, a high bandwidth memory device comprising a thermal management device, a logic die, positioned below the thermal management device, a conductivity layer positioned adjacent to the logic die and a plurality of posts. The plurality of posts may extend between the conductivity layer and the thermal management device. The conductivity layer may be positioned above the logic die.

According to some example, the device further comprises a DRAM stack comprising a plurality of DRAM chips and positioned between the DRAM stack and the conductivity layer. The conductivity layer may further comprise a plurality of holes, wherein the logic die and the DRAM stack may be coupled via electrical connections through the plurality of holes in the conductivity layer. The plurality of holes may be formed by etching, drilling or laser ablation. The conductivity layer may be formed around a plurality of metal rods to form the plurality of holes.

According to some examples, the conductivity layer may have a thickness between 30-150µm. The conductivity layer may have a thickness greater than 100µm.

In some examples, the plurality of posts may be arranged around the periphery of the conductivity layer. The plurality of posts may be between 1-2 mm wide. The plurality of posts may be fusion bonded to the conductivity layer. The conductivity layer and the plurality of posts may comprise diamond, single crystal diamond, polycrystalline diamond, or silicon carbide.

In some examples, the thermal management device may be a heatsink or a cold plate. The logic die may further have grooves to provide a fitted connection with the conductivity layer.

Another aspect of the present disclosure is directed to a method of assembling a high bandwidth memory device comprising forming a conductivity layer and a plurality of posts, positioning the conductivity layer adjacent to a logic die, positioning a DRAM stack above the conductivity layer and a thermal management device above the DRAM stack, positioning the plurality of posts between the conductivity layer and the thermal management device, and encapsulating the conductivity layer, logic die, and DRAM stack into a mold.

In some examples, the method may further comprise etching, drilling or blasting a plurality of holes in the conductivity layer, wherein the logic die is coupled to the DRAM stack by electrical connections through the plurality of holes in the conductivity layer. In some examples, the method may further comprise forming the conductivity layer around a plurality of metal rods to form a plurality of holes, wherein the logic die is coupled to the DRAM stack by electrical connections through the plurality of holes in the conductivity layer.

In some examples, the conductivity layer may have a thickness between 30-150µm. The conductivity layer may have a thickness greater than 100µm. In some examples, the method may further comprise arranging the plurality of posts around the periphery of the conductivity layer. The plurality of posts may be between 1-2 mm wide. The method may further comprise fusion bonding the plurality of posts to the conductivity layer. The conductivity layer and the plurality of posts may be formed from diamond, single crystal diamond, polycrystalline diamond, or silicon carbide.

In some examples, the thermal management device may be a heatsink or a cold plate. The logic die may further have grooves to provide a fitted connection with the conductivity layer.

### BRIEF DESCRIPTION OF THE DRAWINGS

FIG. 1 is a diagram of a cross-sectional view of a high bandwidth memory device according to an aspect of the present disclosure.
FIG. 2A is a diagram of an aerial view of a conductivity layer according to aspects of the present disclosure.
FIG. 2B is a diagram of an aerial view of the conductivity layer according to aspects of the present disclosure.
FIG. 2C is a diagram of an aerial view of the conductivity layer according to aspects of the present disclosure.
FIG 3 is a diagram of a cross-sectional view of another example of a high bandwidth memory device according to aspects of the present disclosure.
FIG. 4A is a diagram of a cross-sectional view of experimental baseline high bandwidth memory.
FIG. 4B is a representation of a heat map of experimental baseline results corresponding to the example structure of FIG. 4A.
FIG. 5A is a diagram of a cross-sectional view of an experimental high bandwidth memory structure.
FIG. 5B is a representative of a heat map of experimental results corresponding to the example structure of FIG. 5A.
FIG. 6A is a diagram of a cross-sectional view of an experimental high bandwidth memory structure.
FIG. 6B is a representative of a heat map of experimental results corresponding to the example structure of FIG. 6A.
FIG. 7A is a diagram of a cross-sectional view of an experimental high bandwidth memory structure.
FIG. 7B is a representative of a heat map of experimental results corresponding to the example structure of FIG. 7A.
FIG. 8 is a flow chart of the method for assembling high bandwidth memory devices according to aspects of this disclosure.

### DETAILED DESCRIPTION

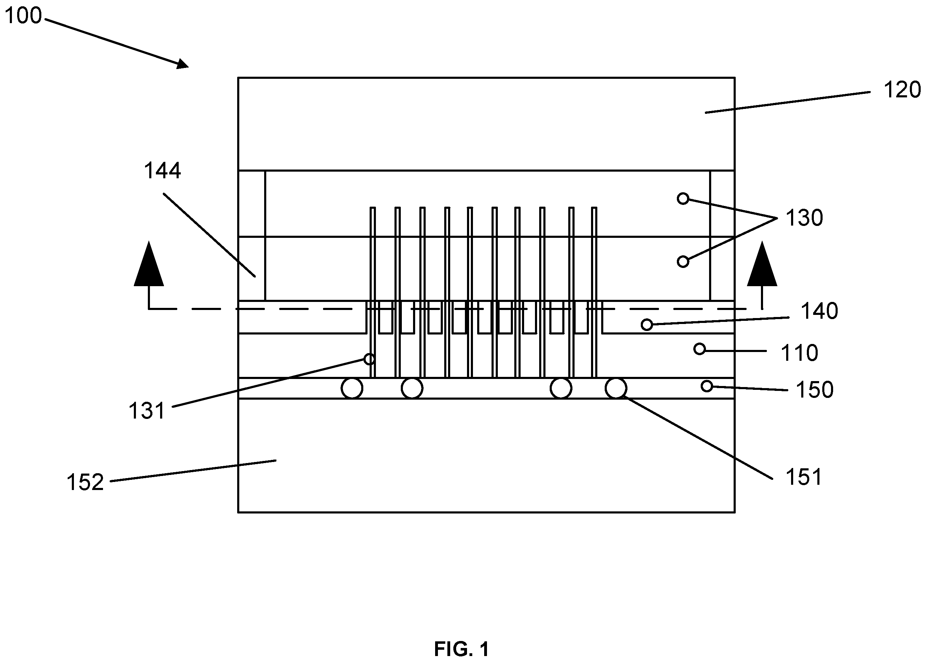

FIG. 1 is a cross-sectional view of a HBM device 100 according to aspects of the present disclosure. The HBM device 100 includes a logic die 110, a thermal management device 120, one or more DRAM chips (collectively referred to as a DRAM stack 130), and a conductivity layer 140 including a plurality of posts 144. In some examples, the HBM 100 may further include underfill 150, one or more micro-bumps 151, and an interposer layer 152. The DRAM stack 130 may be coupled to the logic die 110 via electrical connections 131.

The HBM device 100 generally refers to a type of memory architecture designed to provide significantly higher bandwidth compared to conventional memory systems. HBM technology may be employed in a wide range of computing systems, including but not limited to graphics processing units (GPUs), central processing units (CPUs), application-specific integrated circuits (ASICs), field-programmable gate arrays (FPGAs), and artificial intelligence (AI) accelerators. HBM devices typically comprise vertical DRAM stack 130 interconnected by electrical connections 131, such as through-silicon vias (TSVs), and are often mounted in close proximity to or on top of a logic die 110. This arrangement allows for wide data buses and short signal paths, thereby enabling high data transfer rates and reduced latency.

The logic die 110 may be any semiconductor die configured to perform one or more control, interface, or computational functions in coordination with the memory stack. The logic die 110 is typically positioned at the base of the HBM device 100 and connected to the DRAM stack 130 through electrical connections 131, or vertical interconnects, such as TSVs. The logic die 110 may include circuitry for memory access arbitration, command decoding, data buffering, error correction, power management, or other control logic to facilitate high-speed data exchange between the HBM device 100 and a host device, such as a GPU, CPU, or system-on-chip (SoC). In some examples, the logic die 110 may have an area between 110 and 200 mm2. In some examples, the logic die 110 may have a thickness between 20 and 50 µm.

In some examples, as shown in FIG. 1, the logic die 110 may be positioned on top of an interposer layer 152 through one or more bumps or micro-bumps 151, and an underfill 150. The interposer layer 152 may comprise a silicon, organic, or glass substrate configured to provide high-density routing between the logic die and adjacent system components, such as a GPU. The micro-bumps 151 serve as electrical and mechanical interconnects between the logic die 110 and the interposer layer 152, facilitating high-speed signal transmission and power delivery. An underfill 150 is disposed between the logic die 110 and the interposer layer 152, surrounding the micro-bumps 151 to enhance mechanical stability. The underfill 150 may be made of dielectric material with low thermal conductivity. For example, the thermal conductivity of the underfill 150 may be around 1-2 W/mK. In some examples, the underfill 150 may be positioned between the layers DRAM die of the DRAM stack 130. In some examples, the logic die 110 may be coupled to the interposer layer 152 using hybrid bonding technology, without the use of underfill 150 and micro-bumps 151. For example, the hybrid bonding technology may include silicon oxide fusion bonding.

HBM devices typically exhibit high thermal density due to their three-dimensional stacked architecture and close physical proximity to high-performance computing components such as GPUs or CPUs. To maintain safe and efficient operating temperatures, a thermal management device 120 may be thermally coupled to the HBM device 100 to dissipate heat generated during operation. In some examples, the thermal management device 120 may be a cold plate may be mounted over the HBM device 100, allowing liquid coolant to flow through internal channels within the cold plate to actively transfer heat away from the HBM device 100. In some examples, the thermal management device 120 may be a heatsink. A heatsink is a passive thermal management solution, wherein a thermally conductive metal structure with extended surface area (e.g., fins) facilitates convective and radiative heat dissipation into the surrounding environment.

In some examples, any reference to the thermal heat management device 120 may relate to a variety of other thermal management devices and techniques employed based on system requirements, packaging constraints, or power density. For example, vapor chambers, heat spreaders, thermal interface materials (TIMs), phase-change materials, thermoelectric coolers, or liquid immersion cooling solutions may be used in place of or in conjunction with traditional cooling structures. These alternatives may be selected or tuned to optimize thermal conductivity, minimize temperature gradients, or accommodate specific form factors associated with high-performance computing modules.

The DRAM stack 130 may be a vertically stacked arrangement of DRAM dies. The DRAM stack 130 may include multiple individual memory dies and bonded together using TSVs and micro-bumps to enable high-density vertical interconnects. In some examples, the DRAM stack 130 may include any suitable number of DRAM dies with each die subdivided into multiple channels or banks that may be accessed in parallel to enhance throughput. In some examples, the DRAM stack 130 may comprise two DRAM dies, three DRAM dies, four DRAM dies, eight DRAM dies, ten DRAM dies, etc. Each die within the DRAM stack 130 may be configured to operate according to a memory protocol standard, such as HBM2, HBM2E, or HBM3, and may include circuitry for row decoding, column decoding, sense amplification, and refresh operations.

The conductivity layer 140 may be formed from a high thermal conductivity material. In some examples, a high thermal conductivity material may be any suitable inorganic material with a coefficient of thermal expansion (CTE) comparable to silicon and with a thermal conductivity double to fifteen-fold higher than that of silicon. The high thermal conductivity material assists in spreading the heat more uniformly from the logic die 110 to facilitate the heat transfer to the top surface of the HBM 100 to where the thermal management device 120 makes contact with the DRAM stack 130. Some examples of suitable high thermal conductivity material may be diamond, single crystal diamond (SCD), poly crystalline diamond (PCD), silicon carbide, aluminum nitride, etc. In some examples, the high thermal conductivity material may include ceramics or non-metals. In some examples, the conductivity layer 140 may be comprised of 50% or more of a high thermal conductivity material. These materials will help spread the heat more uniformly on the HBM logic die 110 to help with the heat transfer to the top surface where the thermal management device 120 makes thermal contact with the HBM device 110.

The conductivity layer 140 may be positioned between the logic die 110 and the DRAM stack 130. In some examples, as described more below, the conductivity layer 130 may be positioned beneath the logic die 110, at the bottom of the HBM device. The conductivity layer 140 may have an area that is equal to or greater than the area of the logic die 110.

The conductivity layer 140 may have a thickness between 20- 200µm. In some examples, the thickness of the conductivity layer may be between 30- 100µm. According to the examples below, the thickness of the conductivity layer may contribute to the efficiency and uniformity of heat spreading away from the logic die and any adjacent die. In some examples, the logic die 110 may be thinned or etched to create grooves between the TSV to make room for the conductivity layer 140.

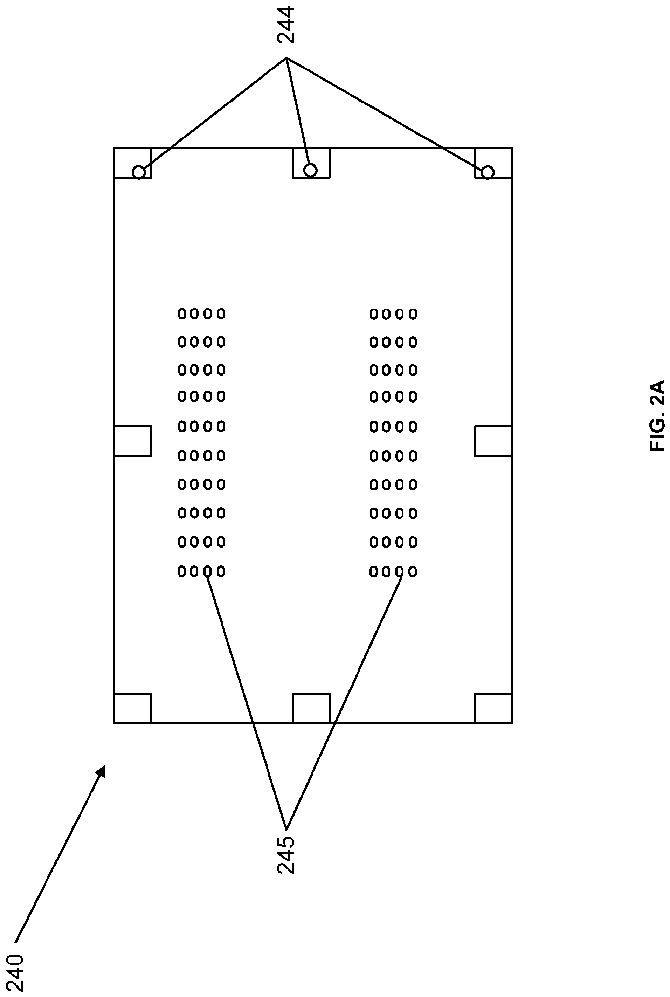

Fig. 2A is an aerial view of a conductivity layer 240 according to aspects of the present disclosure. The conductivity layer 240 includes a plurality of posts 244 and a plurality of holes 245. The plurality of posts 245 creates a high thermal conduction pathway between the logic die and the thermal management device. The heat dissipated from the logic die may travel along the pathway directly to the thermal management device along the side of the DRAM stack. This pathway reduces the chance of hot spots being formed on the logic die by quickly and evenly dispersing the heat away from the logic die. The pathway may also provide an additional route for heat generated by the DRAM stack to move efficiently to the thermal management device.

In some examples, the plurality of posts 244 may be soldered or fusion bonded via an oxide bond to the conductivity layer 240. The number of posts 244 attached to the conductivity layer 240 may vary. In some examples, there may be two posts, four posts, eight posts arranged around the conductivity layer 240. As depicted in FIG. 2A, the plurality of posts 244 may be arranged around the periphery of the conductivity layer. In some examples, the plurality of posts 244 may form a ring around the periphery of the conductive layer. In some examples, the plurality of posts 244 may be in a staggered formation around the conductivity layer 240. In some examples, each of the plurality of posts 244 may have a cylindrical, rectangular, or square shape, or any other suitable shape.

The plurality of posts 244 may be formed of the same material as the conductivity layer 240. In some examples, the plurality of posts 244 may include the high thermal conductivity material as described above. In some examples, each of the plurality of posts 244 may have a diameter between 1-2 mm wide. In some examples, the plurality of posts 244 may have a height that is equal to the distance between the conductivity layer and the thermal management device. In some examples, the plurality of posts 244 may have a height that is less than the distance between the logic die and the thermal management device. For example, the plurality of posts 244 may have a height equal to the height of the adjacent DRAM layer of the DRAM stack. Further, each of the plurality of posts 244 may be stacked on top of another of the plurality of posts 244, such that the collective height is equal to the distance between the logic die and the thermal management device. In such an example, the plurality of posts 244 may be soldered, fused, glued, or otherwise secured together.

The plurality of holes 245 may be formed in the conductivity layer 240 according to one or more of the following methods. In some examples, the plurality of holes 245 are formed in the conductivity layer by etching. The etching rate may be between 0.5µm/min for each etch. The aspect ratio for etching the plurality of holes 245 may be between 5 to 100 µm, wherein the aspect ratio is the ratio of the height or depth of the hole to its diameter. The plurality of holes 245 may be formed by any suitable conventional methods, including but not limited to, etching, Deep Reactive Ion Etching, laser drilling, and chemical etching. In some examples, the plurality of holes 245 may be formed by laser ablation. Using laser ablation, the aspect ratio to form the plurality of holes 245 may be at least between 5 to 100 µm.

In some examples, conductivity layer 240 may be formed around the plurality of holes 245. For example, a carrier plate with multiple metal rods may serve as a forming structure for the conductivity layer 240. Further, a suitable liquid material, such as PCD, may be deposited or poured onto the carrier plate. The material may harden around the multiple rods, creating the plurality of holes 245. Once the material has solidified the resulting conductivity layer 240 may be polished and the carrier plate may be removed from the conductivity layer 240. In some examples, some or all of the multiple metal rods may be removed with the carrier plate. In some examples, some or all of the multiple metal rods may remain in the conductivity layer 240 to later facilitate the electrical coupling of the logic die to the DRAM stack.

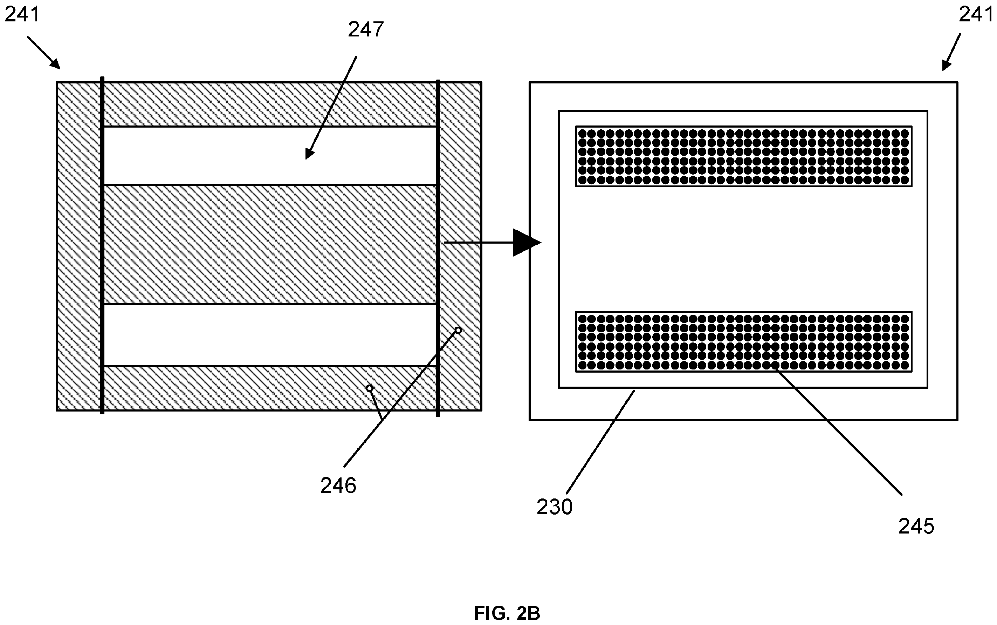

FIG. 2B is an aerial view of another example of a conductivity layer 241 according to aspects of the disclosure. In some examples, the conductivity layer 241 may comprise conductive strips 246 forming windows 247. The conductivity player 241 may comprise a plurality of the conductive strips 246. In some examples, the conductivity layer 241 may comprise three, four, five, six, or seven conductive strips. For example, as depicted in FIG 2B, the conductivity layer 241 comprises five conductive strips 246. The conductive strips 246 may be formed of a high thermal conductivity material. For example, the conductive strips 246 may comprise diamond.

The conductive strips 246 may be positioned such that windows 247 form near the center or middle of the conductive layer 241. In some examples, there may be one, two, or three windows. The windows 247 may assist in the thermal conduction of heat away from the logic die. The windows may serve as through vias for the electrical connections between the logic die and the DRAM stack 230. For example, the logic die may be placed below the conductivity layer 241 and the DRAM stack 230 may be placed above the conductivity layer 241. The windows 246 serve as through vias for the electrical connections between the logic die and the DRAM stack 230. In some examples, the conductivity layer 241 may have a larger area than the DRAM stack 230 such that there is an overhang around the DRAM stack 230 when it is placed on top of the conductivity layer 241.

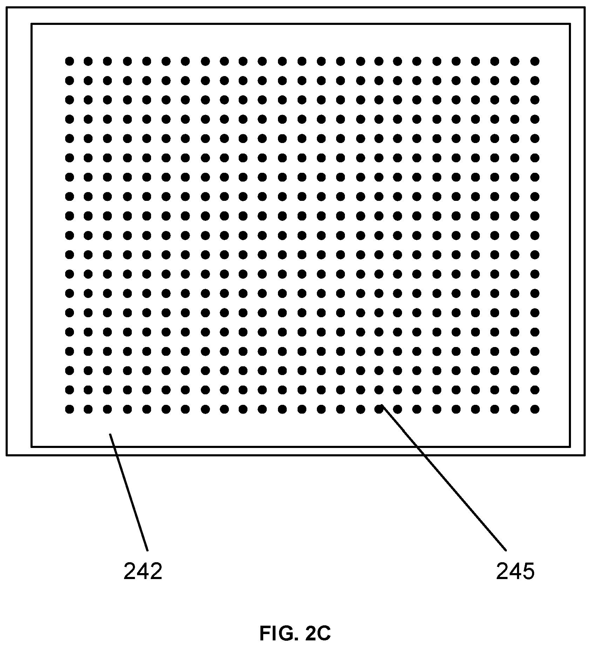

FIG. 2C is an aerial view of yet another example of a conductivity layer 242 according to aspects of the present disclosure. The conductivity layer 242 may comprise a single piece of diamond with a plurality of holes 245. In some examples, the conductivity layer 242 may comprise a plurality of holes 245 clustered in the interior surface area of the conductivity layer. In this example, a large or majority portion of the conductivity layer 242, may include the plurality of holes 245. The holes may be used to facilitate the TSV connections between the logic die and the DRAM stack. The holes may also facilitate the thermal transfer pathway by providing additional vias for heat transfer from the logic die. The conductivity layer 242 positioned above or below the logic die.

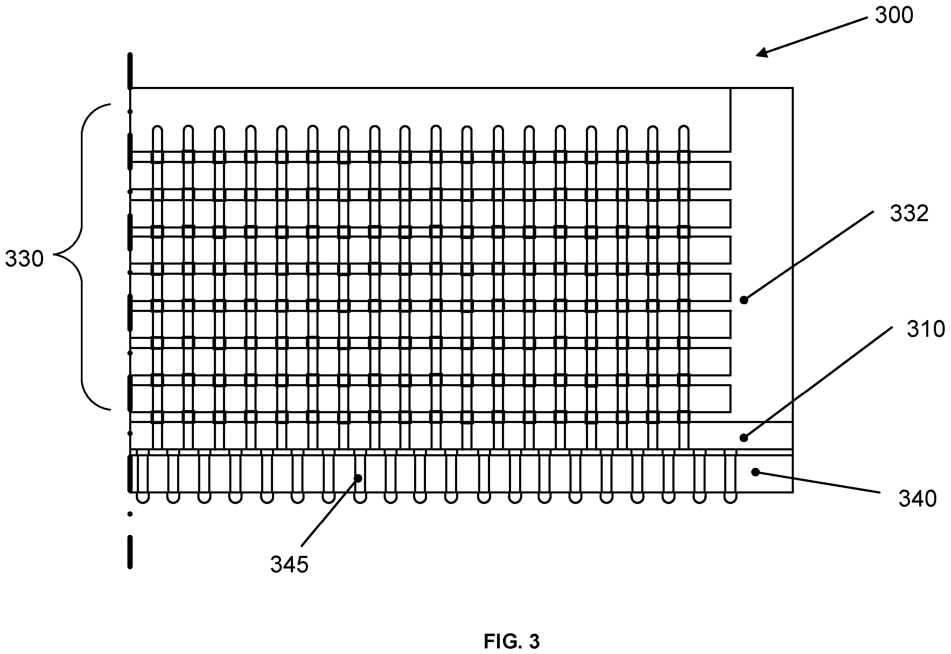

FIG. 3 is a cross-sectional view of an HBM 300 example according to aspects of the present disclosure. The HBM device 300 includes a logic die 310, a thermal management device 320, a DRAM stack 330, and a conductivity layer 340. In this example the conductivity layer 340 is positioned below the logic die 310. The conductivity layer 340 may further include a plurality of holes 345.

In some examples, as depicted in FIG. 3, the HBM device or portions of the HBM device may be encapsulated in a molding 332. In some examples, the molding may encapsulate the DRAM stack 330. In some examples, the molding 332 may be formed such that there is an over mold structure formed to along the sides of the DRAM stack 330. The overmold may serve as an additional thermal conductivity pathway for heat to transfer to the thermal management device. In some examples, the molding material may be the sides for the DRAM stack 330 and not on the top, in order to facilitate heat removal from the top surface of the HBM device. To better facilitate heat spreading, the mold material may be a high thermal conductivity version with thermal conductivity higher than 1 W/mK.

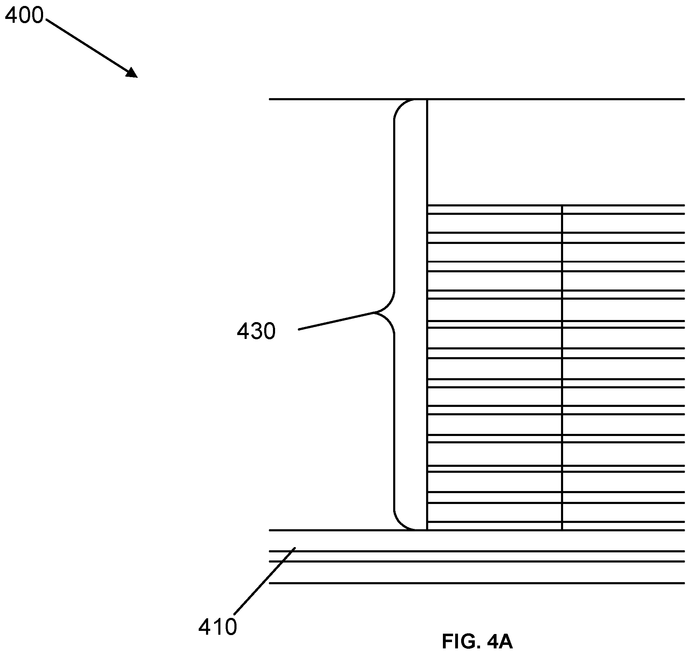

The following paragraphs describe thermal simulation results corresponding to FIGS. 4A-7B. The experiment demonstrates how the thickness and placement of the conductivity layer can affect heat dissipation in areas of the logic die that are most prone to hotspot formation. In general, hotspots tend to form in regions of the logic die where TSVs are located and at the physical layer (PHY), where the logic die connects to adjacent devices.

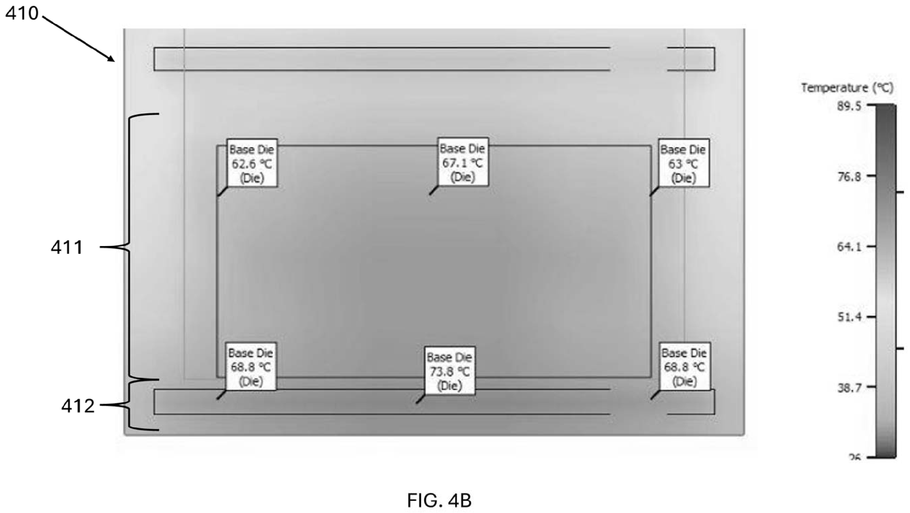

FIGS. 4A-B depict the baseline of the following simulated structure and results wherein the HBM device 400 without a conductivity layer. The DRAM stack 430 and the logic die 410 are interconnected through TSVs. The total heat dissipation per DRAM die of the HBM device 400 was 2.58W and the total heat dissipation of the TSV was 0.436W. Further, the majority of the heat from the DRAM stack is dissipated uniformly across the entire DRAM die surface. The logic die 410 is located at the bottom of the HMB device 400 and the heat is dissipated from the logic die 410 through few localized regions, TSV at 2.5W and PHY at 11.7W. The temperature of the logic die 410 was measured at six distinct spots in the PHY area 411 and TSV area 412. As depicted in the heat map of FIG 4B, the resulting temperatures were 62.6°C, 67.1 °C, 63°C, 68.8 °C, 73.8 °C, and 68.8°C. The maximum recorded logic die temperature is 73.8°C, as recorded below in Table 1. The average temperature of the bottom most DRAM die, i.e. closest to the logic die 410, is 71.1°C.

### Case A

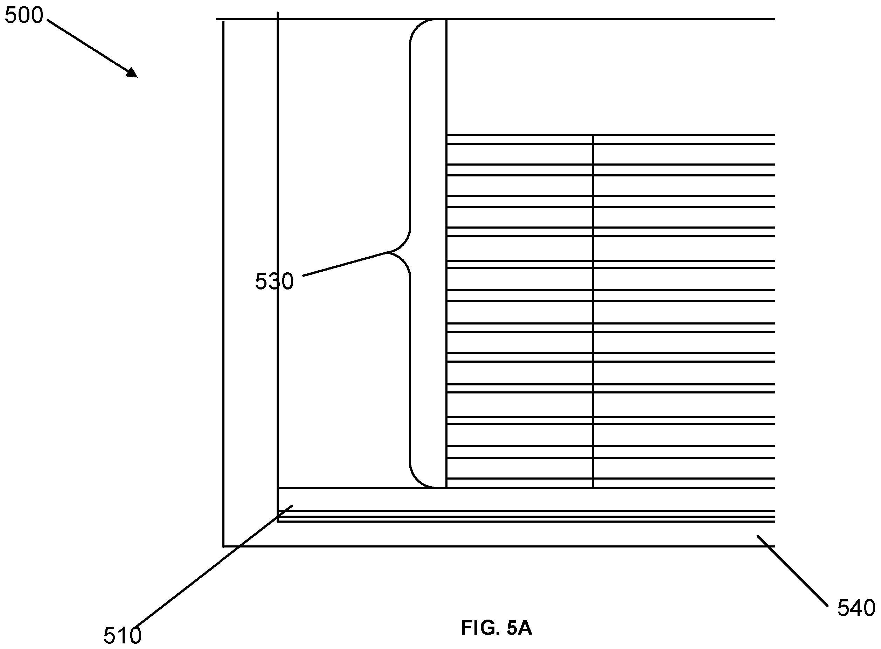

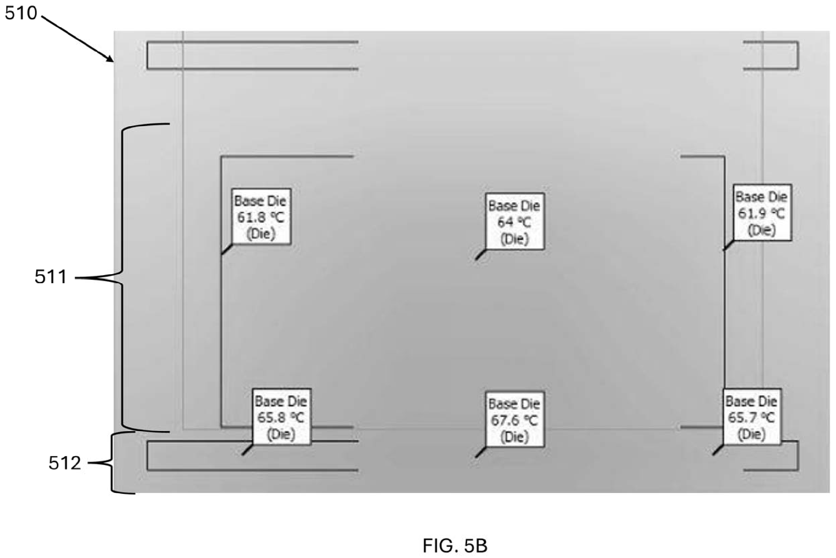

FIGS. 5A-B depicts the simulated structure and results of a HBM device 500 including a DRAM stack 530 and a conductivity layer 540 positioned above the logic die 510. The conductivity layer 610 is formed of diamond and has a thickness of 36.6 µm. The temperature of the logic die 510 was measured at six distinct spots in the PHY area 511 and TSV area 512. As depicted in the heat map of FIG 5B, the resulting temperatures were 61.8°C, 64 °C, 61.9°C, 65.8 °C, 67.6 °C, and 65.7°C. The maximum recorded logic die temperature is 67.6°C, as recorded below in Table 1. The average temperature of the bottom most DRAM die is 66.1°C.

### Case B

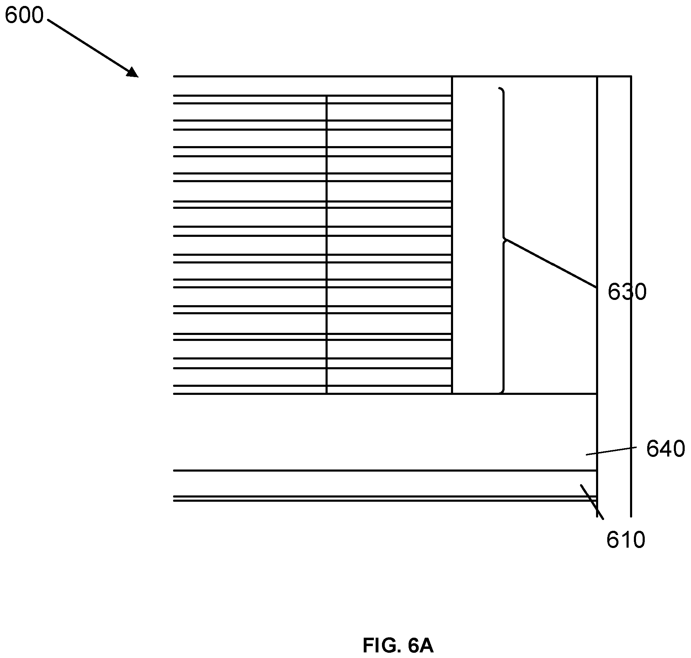

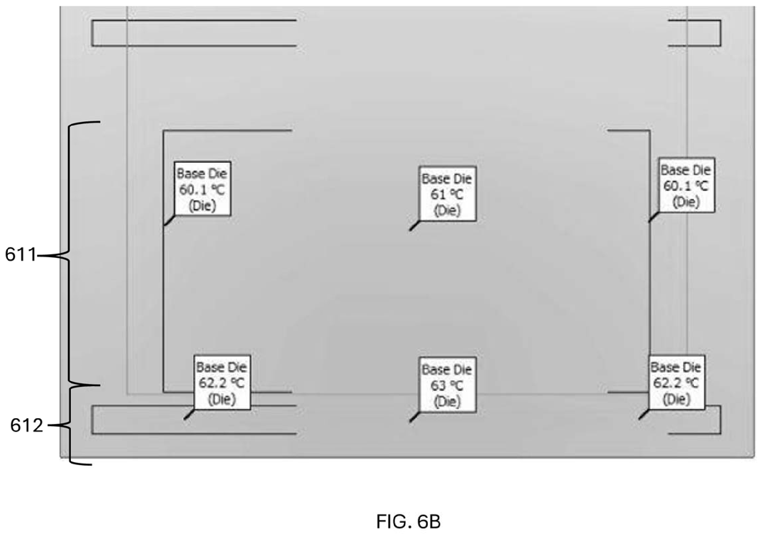

FIGS.6A-B depicts the simulated structure and results of a HBM device 600 including a DRAM stack 630 and a conductivity layer 640 positioned above the logic die 610. The conductivity layer 610 comprises diamond and has a thickness of 141.3 µm. The temperature was measured at six distinct spots in the PHY area 611 and TSV area 612 of the logic die 610. As depicted in the heat map of FIG 6B, the resulting temperatures were 60.1°C, 61 °C, 60.1 °C, 62.2 °C, 63 °C, and 62.2 °C. The maximum recorded logic die temperature is 63°C, as recorded below in Table 1. The average temperature of the bottom most DRAM die is 61.8°C.

### Case C

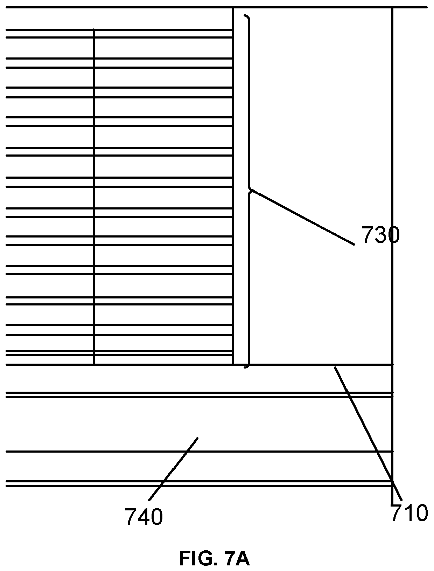

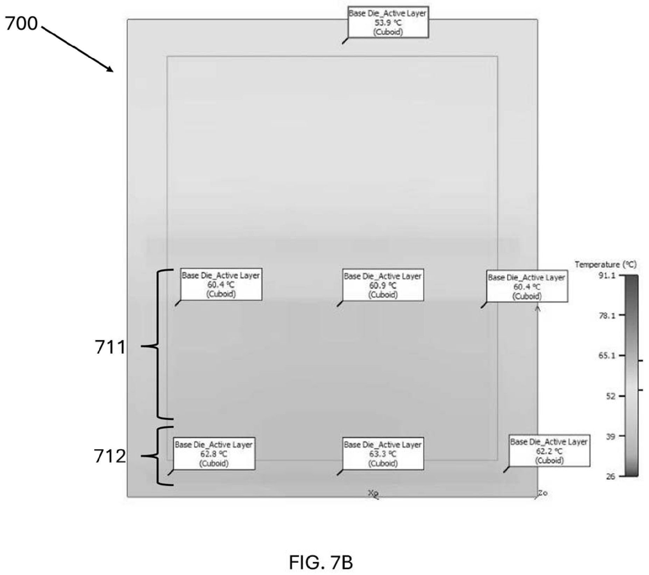

FIGS. 7A-B depicts simulated structure and results of a HBM device 700 including a DRAM stack 730, and a conductivity layer 740 positioned below the logic die 710. The logic die 710 has a thickness of 46.6 µm. The conductivity layer 740 comprises diamond and has a thickness of 141.3µm. The temperature of the logic die 710 was measured at six distinct spots in the PHY area 711 and TSV area 712. As depicted in the heat map of FIG 7B, the resulting temperatures were 60.4°C, 60.9 °C, 60.4 °C, 62.8 °C, 63.3 °C, and 62.2 °C. The maximum recorded logic die temperature is 63.3°C, as recorded below in Table 1. The temperature of the bottom most DRAM die was also measured. The temperature of the bottom most DRAM die was 62.1°C.

The results of the above experiments have been summarized below in Table 1.

**Table 1:**

| | Logic Die Tₘₐₓ (°C) | 1^{st} DRAM Tₘₐₓ (°C) |
|---|---|---|
| Baseline (No diamond layer) | 73.8 | 71.1 |
| Case A (Diamond thickness 36.6, placed on top of logic die) | 67.6 | 66.1 |
| Case B (Diamond thickness 141.3, placed on top of logic die) | 63 | 61.8 |
| Case C (Diamond thickness 141.3, placed on bottom of logic die) | 63.3 | 62.1 |

The conductivity layer helps spread the heat uniformly across the logic die. As shown in the results above, a thicker conductivity layer contributes to a more efficient and uniform spread of the heat generated by the logic die. Additionally, the conductivity layer helps reduce the temperature of the bottom-most DRAM die.

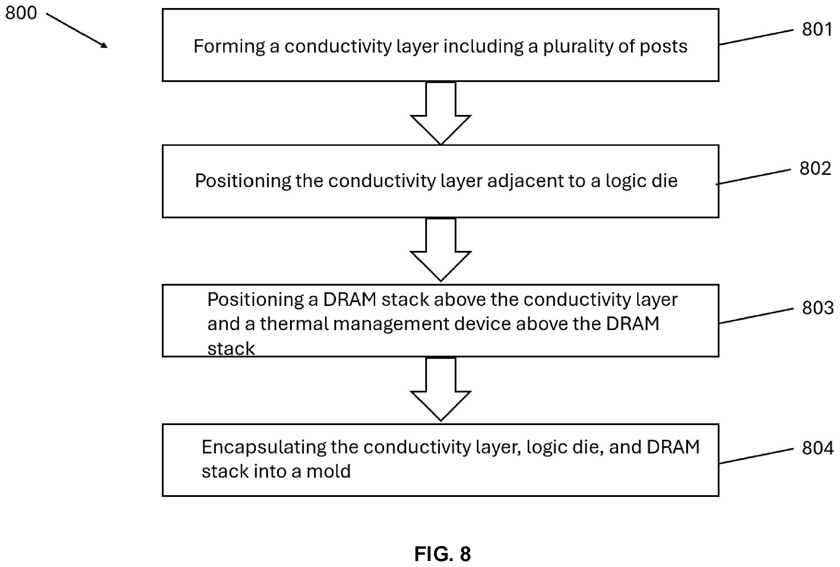

FIG. 8 a flow chart of an example method 800 for assembling high bandwidth memory devices according to the examples described herein.

Block 801 relates to forming a conductivity layer including a plurality of posts. For example, the conductivity layer may comprise a high thermal conductivity material, such as diamond, SCD, PCD, silicon carbide, aluminum nitride, ceramics, non-metals, etc. In some examples, the conductivity layer may be formed of conductivity strips. The conductivity strips may be fused, bonded or glued together. In some examples, the conductivity layer may include four, six, eight, ten posts. The plurality of posts may be arranged around the periphery of the conductivity layer. The plurality of posts may have a diameter between 1-2 mm.

Block 801 may also include forming a plurality of holes in the conductivity layer. The plurality of holes may facilitate electrical connections of components of the HBM device. The plurality of holes may be formed in the conductivity layer by drilling, etching or laser ablation. In some examples, the conductivity layer may be formed around a plurality of metal rod, wherein, when the metal rods are removed, from the plurality of holes. In some examples, the plurality of holes may further contribute to a high thermal conduction pathway.

Block 802 relates to positioning the conductivity layer adjacent to a logic die. The conductivity layer may be positioned above or below the logic die. In some examples, the logic die may comprise grooves to facilitate a fitted connection with the conductivity layer.

Block 803 relates to positioning a DRAM stack above the conductivity layer and a thermal management device above the DRAM stack. The DRAM stack may comprise a plurality of vertically stacked DRAM chips. The DRAM stack and the Logi die may be connected through electrical connections, such as TSV. In some examples, the plurality of holes in the conductivity layer facilitates electrical connections between the DRAM stack and the logic die. The thermal management device may be a heatsink or a cold plate. In some examples, the plurality of posts may extend between the conductivity layer and the thermal management device. Further, the plurality of posts may create a high thermal conduction pathway between the logic die and the thermal management device.

Block 804 relates to encapsulating the conductivity layer, logic die, and the DRAM stack into a mold. The mold may serve as structural support for the components of the HBM device. In some examples the thermal management device may also be encapsulated in the mold. In some examples, the mold may further contribute to the high thermal conduction pathway.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description of the examples should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many possible implementations. Further, the same reference numbers in different drawings can identify the same or similar elements.

## Claims

1. A high bandwidth memory device, comprising:
a thermal management device;
a logic die positioned below the thermal management device;
a conductivity layer positioned adjacent to the logic die; and
a plurality of posts, wherein the plurality of posts extends between the conductivity layer and the thermal management device.

2. The device of claim 1, wherein the conductivity layer is positioned above the logic die.

3. The device of claim 2, further comprising a DRAM stack comprising a plurality of DRAM chips positioned between the thermal management device and the conductivity layer.

4. The device of claim 3, wherein the conductivity layer includes a plurality of holes and wherein the logic die is coupled to the DRAM stack by electrical connections through the plurality of holes in the conductivity layer.

5. The device of claim 4, wherein the plurality of holes is formed in the conductivity layer by etching, drilling or laser ablation; and/or
wherein the conductivity layer is formed around a plurality of metal rods to form the plurality of holes.

6. The device of one of claims 1 to 5, wherein the conductivity layer has a thickness between 30-150 µm.

7. The device of one of claims 1 to 5, wherein the conductivity layer has a thickness greater than 100µm.

8. The device of one of claims 1 to 7, wherein a portion of the plurality of posts are arranged around the periphery of the conductivity layer; and/or
wherein each of the plurality of posts are between 1 and 2 mm wide; and/or
wherein the plurality of posts is fusion bonded to the conductivity layer.

9. The device of one of claims 1 to 8, wherein the conductivity layer and the plurality of posts comprise diamond, single crystal diamond, polycrystalline diamond, or silicon carbide.

10. The device of one of claims 1 to 9, wherein the thermal management device is a heatsink or a cold plate; and/or
wherein the logic die includes grooves to provide a fitted connection with the conductivity layer.

11. A method assembling a high bandwidth memory device, the method comprising:
forming a conductivity layer and a plurality of posts;
positioning the conductivity layer adjacent to a logic die;
positioning a DRAM stack above the conductivity layer and a thermal management device above the DRAM stack,
positioning the plurality of posts between the conductivity layer and the thermal management device; and
encapsulating the conductivity layer, logic die, and DRAM stack into a mold.

12. The method of claim 11, further comprising etching, drilling or blasting a plurality of holes in the conductivity layer, wherein the logic die is coupled to the DRAM stack by electrical connections through the plurality of holes in the conductivity layer.

13. The method of claim 11 or claim 12, wherein the conductivity layer is formed around a plurality of metal rods to form a plurality of holes, wherein the logic die is coupled to the DRAM stack by electrical connections through the plurality of holes in the conductivity layer.

14. The method of claim 12 or claim 13, wherein a portion of the plurality of posts are arranged around the periphery of the conductivity layer; and/or
wherein each of the plurality of posts are between 1 and 2 mm wide.

15. The method of one of claims 12 to 14, further comprising forming grooves in the logic die to provide a fitted connection with the conductivity layer.
